# EUROPEAN PATENT APPLICATION

(11) **EP 3 843 170 A1**
(43) Date of publication of application: **30.06.2021**
(21) Application number: 20216768.0
(22) Date of filing: 23.12.2020
(51) Int. Cl.: H01L 51/52

(54) **DISPLAY PANEL AND DISPLAY DEVICE INCLUDING SAME**

(30) Priority: 27.12.2019 KR 20190176840
(71) Applicant: LG Display Co., Ltd., Seoul 07336 (KR)
(72) Inventor: KIM, Daeyong, 10845 Paju-si (KR); YEO, Jonghoon, 10845 Paju-si (KR); HONG, Hyungi, 10845 Paju-si (KR)
(74) Representative: Morrall, Jonathan Ian McLachlan

(57) **Abstract**

A display panel (100) includes a substrate (110) including an emission area (EA) and a non-emission area (NA); a driving element for driving the display panel; an auxiliary electrode (147) placed in the non-emission area (NA), and spaced apart from the driving element; a protective layer (150) placed on the driving element and the auxiliary electrode (147); a first electrode (161) placed on the protective layer (150), and connected to the driving element; a first organic material layer (171) placed on the first electrode (161); a second electrode (175) placed above the first organic material layer (171) and the protective layer (150); a second organic material layer (173) placed between the second electrode (175) and the first organic material layer (171); and a contact hole (157) penetrating through the protective layer (150), and exposing the auxiliary electrode (147), wherein the second electrode (175) is electrically connected to the auxiliary electrode (147) within the contact hole (157).

## Description

The present application claims priority to Korean Patent Application No. 10-2019-0176840, filed on December 27, 2019.

### BACKGROUND

### Field of the Disclosure

The present disclosure relates to a display panel, a display device including a display panel, and a method of manufacturing a display panel.

### Description of the Background

A display panel includes pixels capable of outputting light. Examples of the display panel include a liquid-crystal display (LCD) panel, a plasma display panel (PDP), and an organic light-emitting diode (OLED) display panel.

Organic light-emitting diodes constituting the OLED panel are self-luminous, and a separate light source is not required. Accordingly, the thickness and the weight of the display device including the OLED panel may be relatively reduced. In addition, the display device including the OLED panel may have high quality characteristics, such as low power consumption, high luminance, a high response rate, and the like.

The foregoing is intended merely to aid in the understanding of the background of the present disclosure, and is not intended to mean that the present disclosure falls within the purview of the related art that is already known to those skilled in the art.

### SUMMARY

Accordingly, the present disclosure provides a display panel, and a display device and including the same, wherein a current is supplied stably to a light-emitting element and the display panel has excellent operating characteristics.

According to aspects of the present disclosure, there is provided a display panel including: a substrate including an emission area and a non-emission area; a driving element for driving the display panel; an auxiliary electrode placed in the non-emission area, and spaced apart from the driving element; a protective layer placed on the driving element and the auxiliary electrode; a first electrode placed on the protective layer, and connected to the driving element; a first organic material layer placed on the first electrode; a second electrode placed above the first organic material layer and the protective layer; a second organic material layer placed between the second electrode and the first organic material layer; and a contact hole penetrating through the protective layer, and exposing the auxiliary electrode, wherein the second electrode is electrically connected to the auxiliary electrode within the contact hole.

According to aspects of the present disclosure, there is provided a method of manufacturing a display panel, the method including: forming, on a substrate, a driving element for driving the display panel, and an auxiliary electrode spaced apart from the driving element; forming a protective layer on the driving element and the auxiliary electrode; forming a first electrode connected to the driving element; forming, in the protective layer, a contact hole exposing the auxiliary electrode; forming a first organic material layer on the first electrode; forming a second organic material layer on the first organic material layer and the protective layer; and forming a second electrode in such a manner as to cover the second organic material layer, wherein the forming of the second organic material layer includes forming the second organic material layer that is placed in such a manner as to be discontinuous within the contact hole.

According to the aspects of the present disclosure, the second electrode corresponding to the cathode electrode of the light-emitting element may be connected to the auxiliary wire through the auxiliary electrode, so that the power supplied through the auxiliary wire may be supplied stably to the second electrode.

Accordingly, a current may be supplied stably to the light-emitting element of the aspects of the present disclosure.

### BRIEF DESCRIPTION OF THE DRAWINGS

The above features and other advantages of the present disclosure will be more clearly understood from the following detailed description when taken in conjunction with the accompanying drawings, in which:
FIG. 1 is a diagram showing a display device according to aspects of the present disclosure;
FIG. 2 is a diagram showing a display device according to aspects of the present disclosure;
FIG. 3 is a diagram showing a pixel according to aspects of the present disclosure;
FIG. 4 is a cross-sectional view of a display panel according to aspects of the present disclosure;
FIG. 5 is an enlarged view of portion AA shown in FIG. 4;
FIGs. 6 to 15 are diagrams showing a process of manufacturing a display panel according to aspects of the present disclosure;
FIG. 16 is a diagram showing a display panel according to aspects of the present disclosure;
FIG. 17 is a diagram showing a display panel according to aspects of the present disclosure; and
FIG. 18 is a diagram showing a display panel according to aspects of the present disclosure.

### DETAILED DESCRIPTION

Hereinafter, aspects of the present disclosure will be described with reference to the accompanying drawings.

When it is mentioned that a first element "is connected or coupled to", "contacts or overlaps", etc. a second element, it should be interpreted that, not only can the first element "be directly connected or coupled to", "directly contact or overlap", the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When it is mentioned that a first element is "on", "formed on", or "placed on" etc a second element, this it should be interpreted that, not only can the first element be "directly on", directly placed on" or "directly formed on" or "directly above, placed above, or formed above", the second element, but a third element can also be interposed between the first and second elements.

When it is mentioned that a first element is "above", "formed above" or "placed above" etc a second element, this should not be interpreted as a strict specific orientation of the features and should be interpreted to convey the positional relation between the two features in an orientation that can be rotated such that the first element is "under", "formed under", or "placed under" the second element.

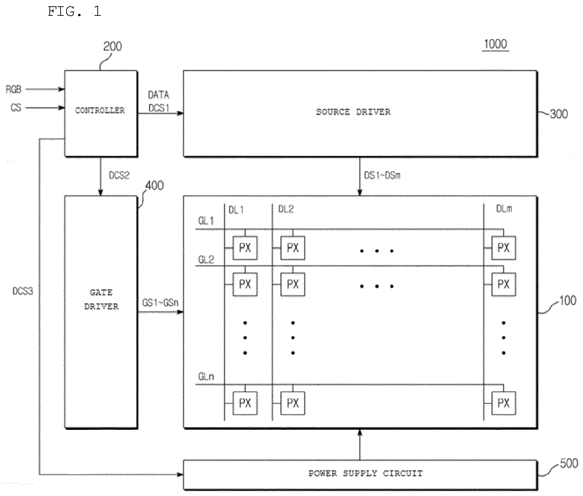

FIG. 1 is a diagram showing a display device according to aspects of the present disclosure. Referring to FIG. 1, a display device 1000 may include a display panel 100, a controller 200, a source driver 300, a gate driver 400, and a power supply circuit 500.

The display device 1000 may be a device capable of displaying images and videos. For example, the display device 1000 may refer to a TV, a smartphone, a tablet personal computer (PC), a mobile phone, a video phone, an e-book reader, a computer, a camera, a wearable device, or the like, but is not limited thereto.

The display panel 100 may include multiple pixels (or subpixels) PXs arranged in rows and columns. According to aspects, the multiple pixels PXs shown in FIG. 1 may be arranged in a grid structure composed of n rows and m columns (n and m are natural numbers).

For example, the display panel 100 may be implemented as one among a liquid crystal display (LCD), a light-emitting diode (LED) display, an organic light-emitting diode (OLED) display, an active-matrix organic light-emitting diode (AMOLED) display, an electrochromic display (ECD), a digital mirror device (DMD), an actuated mirror device (AMD), a grating light valve (GLV), a plasma display panel (PDP), an electroluminescent display (ELD), a vacuum fluorescent display (VFD), but is not limited thereto.

According to aspects, the display panel 100 may include: n gate lines GL1 to GLn arranged in m rows; and m data lines DL1 to DLm arranged in m columns. The pixels PXs may be placed at intersections of the gate lines GL1 to GLn and the data lines DL1 to DLm.

According to aspects, the pixels PXs of the display panel 100 may be driven on a per-gate line basis. For example, pixels arranged in one gate line may be driven during a first period, and pixels arranged in another gate line may be driven during a second period after the first period. Herein, a unit time period in which the pixels PXs are driven may be referred to as one horizontal period (1 horizontal (1H) time).

The pixels PXs may include a light-emitting element configured to emit light, and a light-emitting element driving circuit driving the light-emitting element. The light-emitting element driving circuit may be connected to one gate line and one data line. The light-emitting element may be positioned between the light-emitting element driving circuit and a power supply voltage (for example, a ground voltage) for connection.

According to aspects, the light-emitting element may be a light-emitting diode (LED), an organic light-emitting diode (OLED), a quantum-dot light-emitting diode (QLED), or a micro light-emitting diode (LED), but the aspects of the present disclosure are not limited to the type of light-emitting element.

Each of the pixels PXs may be one among a red element R outputting red light, a green element G outputting green light, a blue element B outputting blue light, and a white element W outputting white light. In the display panel 100, red elements, green elements, blue elements, and white elements may be arranged in various ways.

The light-emitting element driving circuit may include a switching element connected to the gate lines GL1 to GLn, for example, a thin-film transistor (TFT). When a gate-on signal is applied through the gate lines GL1 to GLn and the switching element is turned on, the light-emitting element driving circuit supplies, to the light-emitting element, a data signal (or a pixel signal) received through the data lines DL1 to DLm connected to the light-emitting element driving circuit. The light-emitting element may output light corresponding to an image signal.

The controller 200 may receive an image signal RGB from the outside, and may perform image processing on the image signal RGB or conversion to make the image signal appropriate for a structure of the display panel 100, thereby generating an image data DATA. The controller 200 may transmit the image data DATA to the source driver 300.

The controller 200 may receive a control signal CS from an external host device. The control signal CS may include a horizontal synchronization signal, a vertical synchronization signal, and a clock signal, but is not limited thereto.

The controller 200 may generate, on the basis of the received control signal CS, a first driving control signal DCS1 for controlling the source driver 300, a second driving control signal DCS2 for controlling the gate driver 400, and a third driving control signal DCS3 for controlling the power supply circuit 500.

The controller 200 may transmit the first driving control signal DCS1 to the source driver 300, may transmit the second driving control signal DCS2 to the gate driver 400, and may transmit the third driving control signal DCS3 to the power supply circuit 500.

The source driver 300 may generate, on the basis of image data DATA and the first driving control signal DCS1, data signals DS1 to DSm corresponding to an image displayed on the display panel 100, and may transmit the generated data signals DS1 to DSm to the display panel 100. The data signals DS1 to DSm may be transmitted to the pixels PXs, respectively. For example, during a 1H period, the source driver 300 may provide data signals DS1 to DSm to be displayed in the 1H period, to the pixels PXs driven in the 1H period through the data lines DL1 to DLm.

The gate driver 400 may provide gate signals GS1 to GSn sequentially to the multiple gate lines GL1 to GLn in response to the second driving control signal DCS2. Each of the gate signals GS1 to GSn is a signal for turning on the pixel PXs connected to each of the gate lines GL1 to GLn, and may be applied to a gate terminal of a transistor included in each of the pixels PXs.

The power supply circuit 500 may generate, on the basis of the third driving control signal DCS3, a driving voltage DV to be provided to the display panel 100, and may transmit the generated driving voltage DV to the display panel 100. The driving voltage DV may include a low-potential driving voltage, and a high-potential driving voltage having higher potential than the low-potential driving voltage. According to aspects, the power supply circuit 500 may transmit the low-potential driving voltage and the high-potential driving voltage individually to each of the pixels PXs through separate power lines.

In this specification, the source driver 300 and the gate driver 400 may be referred to as a panel driving circuit.

According to aspects, at least two among the controller 200, the source driver 300, and the gate driver 400 may be implemented as one integrated circuit. In addition, according to aspects, the source driver 300 or the gate driver 400 may be implemented as being mounted on the display panel 100. In addition, according to aspects, the power supply circuit 500 may be positioned outside the display panel 100.

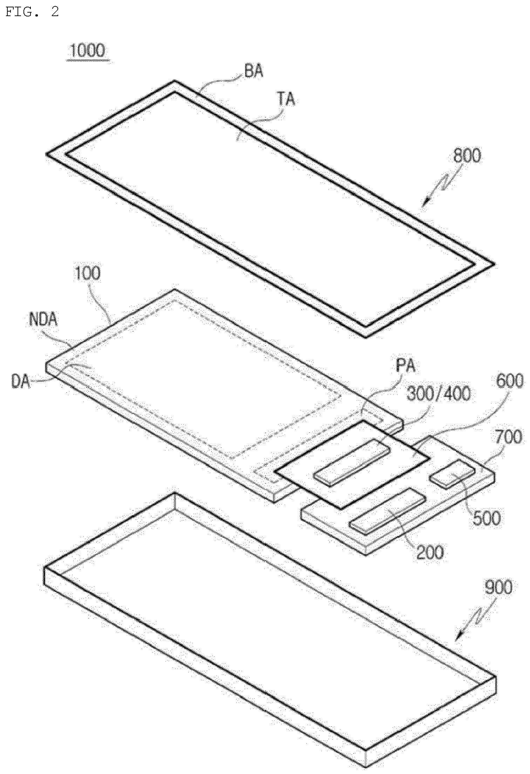

FIG. 2 is a diagram showing a display device according to aspects of the present disclosure. Referring to FIG. 2, the display device 1000 may include: a first circuit substrate 600 connected to the display panel 100; a second circuit substrate 700 connected to the first circuit substrate 600; a cover window 800; and a back cover 900.

The display panel 100 may be placed under the cover window 800. The light emitted from the display panel 100 may be output through the cover window 800.

The display panel 100 may include a display area DA in which light is output, and a non-display area NDA in which light is not displayed.

The display area DA is an area including multiple pixels PXs, and may be referred to as an active area. In the display area DA, a light-emitting material capable of outputting light may be placed. For example, in the display area DA, any one among red light, green light, and blue light, and a combination thereof may be output.

The non-display area NDA may be placed along the periphery of the display area DA. The non-display area NDA refers to an area on the display panel 100 except the display area DA. According to aspects, the gate driver 400 may be placed in the non-display area NDA, but no limitation to this is imposed.

The display panel 100 may further include a pad area PA in which signals are received and output. According to aspects, in the pad area PA, conductive bumps through which signals are input and output may be placed.

The first circuit substrate 600 may be positioned between the display panel 100 and the second circuit substrate 700 for connection, or may electrically connect the display panel 100 and the first circuit substrate 600.

According to aspects, the first circuit substrate 600 may be attached to the pad area PA of the display panel 100. According to aspects, the first circuit substrate 600 may be connected to the bumps placed in the pad area PA, and may transmit a signal through the bumps. For example, the first circuit substrate 600 may include multiple wires for connecting the bumps of the display panel 100 and wires formed on the second circuit substrate 700.

On the first circuit substrate 600, the source driver 300 or the gate driver 400 may be mounted. According to aspects, the first circuit substrate 600 may transmit a signal transmitted from the source driver 300 or the gate driver 400, to the display panel 100.

According to aspects, the first circuit substrate 600 may be implemented as a flexible film, but is not limited thereto.

The second circuit substrate 700 may be connected to the first circuit substrate 600. According to aspects, the second circuit substrate 700 may transmit a signal to the display panel 100 through the first circuit substrate 600.

On the second circuit substrate 700, the controller 200 or the power supply circuit 500 may be mounted. The second circuit substrate 700 may transmit controls signals transmitted from the controller 200, to the first circuit substrate 600, or may transmit driving voltages supplied from the power supply circuit 500, to the first circuit substrate 600. For example, the second circuit substrate 700 may include wires connected to the respective wires formed on the first circuit substrate 600.

According to aspects, the second circuit substrate 700 may be a printed circuit board, but is not limited thereto.

The cover window 800 may transmit the light output from the display panel 100, and may display the light outward. According to aspects, the cover window 800 may include: a light-transmitting area TA that transmits the light provided from the display panel 100; and a light-blocking area BA that does not transmit the light. For example, the light-blocking area BA may be a bezel.

According to aspects, the cover window 800 may include the light-transmitting area TA. In this case, the light output from the display panel 100 may be output through all surfaces of the cover window 800.

The cover window 800 may be a transparent material. According to aspects, the cover window 800 may be glass, plastic, sapphire, crystal, a film, or the like, but is not limited thereto. The cover window 800 may be any material capable of transmitting the light output from the display panel 100.

The back cover 900 may be placed at the bottom of the display device 1000, and may hold the cover window 800 and the display panel 100 therein. According to aspects, the back cover 900 may be coupled with the cover window 800 and may thus hold the display panel 100 therein.

The back cover 900 may be made of a material having rigidity.

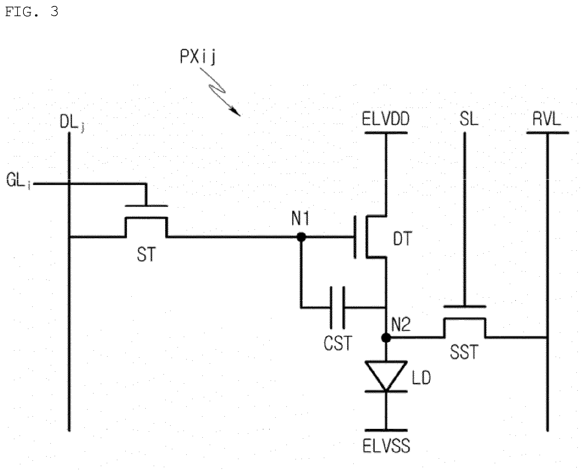

FIG. 3 is a diagram showing a pixel according to aspects of the present disclosure. FIG. 3 shows, as an example, a pixel PXij that is connected to an i-th gate line GLi (1≤i≤n) and a j-th data line DLj (1≤j≤m).

Referring to FIGS. 1 to 3, the pixel PX may include a switching transistor ST, a driving transistor DT, a storage capacitor CST, a sensing transistor SST, and a light-emitting element LD. The switching transistor ST and the driving transistor DT may be referred to as driving elements.

A first electrode (for example, a source electrode) of the switching transistor ST is electrically connected to the j-th data line DLj, and a second electrode (for example, a drain electrode) of the switching transistor ST is electrically connected to a first node N1. A gate electrode of the switching transistor ST is electrically connected to the i-th gate line GLi. The switching transistor ST is turned on when a gate signal at a gate-on level is applied through the i-th gate line GLi, and transmits a data signal applied through the j-th data line DLj, to the first node N1.

A first electrode of the storage capacitor CST is electrically connected to the first node N1, and a second electrode of the storage capacitor CST receives a high-potential driving voltage ELVDD. The storage capacitor CST may be charged with a voltage corresponding to the difference between a voltage applied to the first node N1 and the high-potential driving voltage ELVDD.

A first electrode (for example, a source electrode) of the driving transistor DT receives the high-potential driving voltage ELVDD, and a second electrode (for example, a drain electrode) of the driving transistor DT is electrically connected to a first electrode (for example, an anode electrode) of the light-emitting element LD. A gate electrode of the driving transistor DT is electrically connected to the first node N1. The driving transistor DT is turned on when a voltage at a gate-on level is applied through the first node N1, and may control the amount of a driving current flowing to the light-emitting element LD depending on a voltage provided to the gate electrode.

A first electrode (for example, a source electrode) of the sensing transistor SST is electrically connected to a second node N2, and a second electrode (for example, a drain electrode) of the sensing transistor SST is electrically connected to a reference voltage line RVL. A gate electrode of the sensing transistor SST is electrically connected to a sensing line SL. The switching transistor ST may be turned on the basis of a sensing voltage transmitted through the sensing line SL, and may apply a reference voltage transmitted through the reference voltage line RVL, to the first electrode (for example, the source electrode) of the driving transistor DT through the second node N2.

In addition, the sensing transistor SST may detect the degree of deterioration of the pixel PX (or the driving transistor DT), and may transmit a result of detection to the source driver 300. For example, the sensing transistor SST may sense a threshold voltage of the pixel PXij to identify the degree of deterioration of the pixel PXij. Specifically, the sensing transistor SST may sense the threshold voltage by detecting the voltage of the second node N2.

The light-emitting element LD outputs light corresponding to the driving current. The light-emitting element LD may output light corresponding to any one among red, green, blue, and white colors. The light-emitting element LD may be an organic light-emitting diode (OLED) or an ultra-small inorganic light-emitting diode having a size in a micro to nanoscale range, but is not limited thereto. Hereinafter, an aspect of the present disclosure in which the light-emitting element LD is an organic light-emitting diode will be described.

In addition, the structure of the pixels PXs described in the present disclosure is not interpreted as being limited to the structure of the pixel PXij described with reference to FIG. 3. According to aspects, the pixels PXs may further include at least one element for compensating for a threshold voltage of the driving transistor DT, or initializing a voltage of the gate electrode of the driving transistor DT and/or a voltage of the anode electrode of the light-emitting element LD.

FIG. 3 shows an example in which the switching transistor ST and the driving transistor DT are NMOS transistors, but no limitation thereto is imposed. For example, at least some or all of the transistors constituting each pixel PX may be configured as a PMOS transistor. In various aspects, each of the switching transistor ST and the driving transistor DT may be implemented as a low-temperature polycrystalline silicon (LTPS) thin-film transistor, an oxide thin-film transistor (oxide TFT), or a low-temperature polycrystalline oxide (LTPO) thin-film transistor, but is not limited thereto.

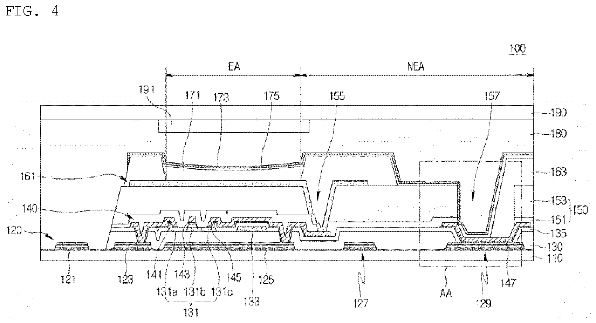

FIG. 4 is a cross-sectional view of a display panel according to aspects of the present disclosure. A structure of the display panel 100 will be described with reference to FIGS. 1 to 4.

A substrate 110 is a base member of the display panel 100, and may be a light-transmissive substrate. The substrate 110 may be a rigid substrate including glass or tempered glass, or may be a flexible substrate made of a plastic material. For example, the substrate 110 may be made of glass or a plastic material, such as polyimide (PI), polyethylene terephthalate (PET), polyethylene naphthalate (PEN), polycarbonate (PC), and the like, but the material of the substrate 110 is not limited thereto.

On the substrate 110, a first conductive layer 120 including a pad 121, a power supply wire 123, a lower wire 125, a data line 127, and an auxiliary wire 129 may be placed.

The pad 121 may receive a signal for driving the panel from the panel driving circuit. According to aspects, the pad 121 may be electrically connected to the first circuit substrate 600, and may receive a data signal or a gate signal from the first circuit substrate 600.

The power supply wire 123 may be a conductive wire for transmitting a driving voltage to the light-emitting element LD. According to aspects, the power supply wire 123 may be a conductive wire through which the high-potential driving voltage ELVDD is applied, but is not limited thereto.

The lower wire 125 may be a conductive metal having a light-blocking function. According to aspects, the lower wire 125 may protect the driving elements of the display panel 100 from external light.

The data line 127 may be a conductive wire for transmitting a data signal to a pixel PX. The data line 127 may be electrically connected to the data lines DL1 to DLm. According to aspects, the data line 127 may refer to the data lines DL1 to DLm.

The auxiliary wire 129 may be placed spaced apart from the data line 127 and the lower wire 125. According to aspects, the auxiliary wire 129 may be connected to the power supply line through which the low-potential driving voltage ELVSS is applied. As will be described later, the low-potential driving voltage ELVSS may be transmitted to the light-emitting element LD through the auxiliary wire 129.

In the meantime, FIG. 4 shows that the first conductive layer 120 has a two-layer structure, but aspects of the present disclosure are not limited thereto.

According to aspects, between the first conductive layer and the substrate 110, an insulation film may be further placed.

On the substrate 110, a buffer layer 130 may be placed. According to aspects, the buffer layer 130 may be placed on the first conductive layer 120. In the meantime, the pad 121 may be exposed without being covered by the buffer layer 130. For example, the pad 121 may not be covered by the insulation layer thereon, or the like, and may receive an electrical signal provided from the outside.

The buffer layer 130 may prevent diffusion of ions or impurities from the substrate 110, and may block moisture penetration from the substrate 110.

The buffer layer 130 may be provided in a multi-layer structure including at least two layers. According to aspects, the buffer layer 130 may include layers containing: an inorganic material, such as an oxide, a nitride, and the like; an organic material; or an organic-inorganic compound. For example, the buffer layer 130 may be silicon oxide or silicon nitride.

On the buffer layer 130, an active pattern 131 and a storage electrode 133 may be placed.

The active pattern 131 may include a silicon-based semiconductor material or an oxide-based semiconductor material. For example, the silicon-based semiconductor material may include amorphous silicon or polycrystalline silicon. The oxide-based semiconductor material may include a quaternary metal oxide, such as an indium tin gallium zinc oxide (InSnGaZnO); a ternary metal oxide, such as an indium gallium zinc oxide (InGaZnO), an indium tin zinc oxide (InSnZnO), an indium aluminum zinc oxide (InAIZnO), a tin gallium zinc oxide (SnGaZnO), an aluminum gallium zinc oxide (AIGaZnO), or a tin aluminum zinc oxide (SnAIZnO); or a binary metal oxide, such as an indium zinc oxide (InZnO), a tin zinc oxide (SnZnO), an aluminum zinc oxide (AlZnO), a zinc magnesium oxide (ZnMgO), a tin magnesium oxide (SnMgO), an indium magnesium oxide (InMgO), an indium gallium oxide (InGaO), an indium oxide (InO), a tin oxide (SnO), or a zinc oxide(ZnO).

The active pattern 131 may be an active area of the driving transistor DT. According to aspects, the active pattern 131 may include a drain region 131a, a first source region 131c, and a first channel region 131b between the first drain region 131a and the source region 131c. For example, the first source region 131c and the first drain region 131a may contain p-type or n-type impurities. Electrons or holes may flow from the first source region 131c, may pass through the first channel region 131b, and may be introduced into the first drain region 131a.

The storage electrode 133 may be placed so that at least a part of the storage electrode 133 and the lower wire 125 overlap. Between the lower wire 125 and the storage electrode 133, a storage capacitor CST may be formed.

An insulation layer 135 may be placed on the active pattern 131 and the storage electrode 133. According to aspects, the insulation layer 135 may be placed between the active pattern 131 and a gate electrode 143, which will be described later. For example, the insulation layer 135 may be placed between the gate electrode 143 and the channel 131b of the active pattern 131.

The insulation layer 135 may be a silicon oxide (SiOx), a silicon nitride (SiNx), or in a multi-layer structure including them.

On the insulation layer 135, a second conductive layer 140 including a source electrode 141, a gate electrode 143, a drain electrode 145, and an auxiliary electrode 147 may be placed.

The gate electrode 143 may include any one or an alloy of two or more selected from a group consisting of molybdenum (Mo), aluminum (Al), chromium (Cr), gold (Au), titanium (Ti), nickel (Ni), neodymium (Nd), and copper (Cu). In addition, the gate electrode 143 may include multiple layers composed of any one or an alloy of two or more selected from a group consisting of molybdenum (Mo), aluminum (Al), chromium (Cr), gold (Au), titanium (Ti), nickel (Ni), neodymium (Nd), and copper (Cu). For example, the gate electrode 143 may include two layers of molybdenum and aluminum-neodymium, or molybdenum and aluminum, but is not limited thereto. In the meantime, FIG. 4 shows that the gate electrode 143 has a two-layer structure, but aspects of the present disclosure are not limited thereto.

The source electrode 141 and the drain electrode 145 are placed spaced apart from each other. The source electrode 141 and the drain electrode 145 may be connected to the source region 131a and the drain region 131c of the active pattern 131, respectively.

According to aspects, the source electrode 141 may be connected to the power supply wire 123 through a contact hole penetrating through the buffer layer 130 and the insulation layer 135. The drain electrode 145 may be connected to a lower electrode LE through a contact hole penetrating through the buffer layer 130 and the insulation layer 135. Accordingly, an electrical signal transmitted via the power supply wire 123 may be transmitted to the drain electrode 145 through the source electrode 141.

The source electrode 141 and the drain electrode 145 may be formed as a single layer or multiple layers composed of any one or an alloy of two or more selected from a group consisting of molybdenum (Mo), aluminum (Al), chromium (Cr), gold (Au), titanium (Ti), nickel (Ni), neodymium (Nd), and copper (Cu). In the case where the source electrode 141 and the drain electrode 145 are multiple layers, they may be composed of two layers of molybdenum and aluminum-neodymium, or three layers of titanium and aluminum and titanium; molybdenum and aluminum and molybdenum; or molybdenum and aluminum-neodymium and molybdenum. In the meantime, FIG. 4 shows that the source electrode 141 and the drain electrode 145 have a two-layer structure, but aspects of the present disclosure are not limited thereto.

The active pattern 131, the source electrode 141, the gate electrode 143, and the drain electrode 145 may constitute a transistor. According to aspects, the transistor may be, for example, the driving transistor DT or the switching transistor ST. FIG. 4 shows an example that the active pattern 131, the source electrode 141, the gate electrode 143, and the drain electrode 145 constitute the driving transistor DT.

In the meantime, FIG. 4 shows a planar TFT type that the source electrode 141, the gate electrode 143, and the drain electrode 145 are positioned on one plane, but aspects of the present disclosure are not limited thereto. For example, on the gate electrode 143, an interlayer insulation layer may be further positioned. The source electrode 141 and the drain electrode 145 may be placed on the interlayer insulation layer.

The auxiliary electrode 147 may be electrically connected to the auxiliary wire 129. According to aspects, the auxiliary electrode 147 may be in contact with the auxiliary wire 129 through a contact hole penetrating through the buffer layer 130 and the insulation layer 135. The auxiliary electrode 147 may be composed of the same material as the source electrode 141 and the drain electrode 145, and may be formed as a single layer or multiple layers.

According to aspects, the auxiliary electrode 147 may be placed in such a manner as to have a slope. That is, the auxiliary electrode 147 may include a first portion placed on the auxiliary wire 129, and a second portion placed on the auxiliary wire 129 and a protective layer 150. The first portion and the second portion may be at an angle to each other.

On the second conductive layer 140, the protective layer 150 may be placed. The protective layer 150 may cover the second conductive layer 140 and the active pattern 131. The protective layer 150 may be a layer including at least one among an organic film and an inorganic film having an insulation function, a planarizing function, or a waterproofing function.

The protective layer 150 may include a first protective layer 151, and a second protective layer 153 placed on the first protective layer 151. The first protective layer 151 may insulate the second conductive layer 140 and the active pattern 131. According to aspects, the first protective layer 151 may include a silicon oxide film (SiOx), a silicon nitride film (SiNx), and multiple films including them. For example, the first protective layer 151 may be a passivation layer.

According to aspects, the first protective layer 151 may include multiple layers, and an additional conductive layer may be further formed between the multiple layers included in the first protective layer 151. The conductive layer formed in the first protective layer 151 may further include electrodes of circuit elements and driving lines, for example, an auxiliary gate electrode of the transistors DT and ST, an upper electrode of the storage capacitor CST, and the like. For example, the first protective layer 151 may be a passivation layer.

The second protective layer 153 may be placed on the first protective layer 151. The second protective layer 153 may be a planarizing film for reducing the difference in level between the layers under the second protective layer 153. According to aspects, the second protective layer 153 may include an organic material such as polyimide, benzocyclobutene series resin, acrylate, and the like. For example, the second protective layer 153 may be an overcoat layer.

According to aspects, any one among the first protective layer 151 and the second protective layer 153 may be omitted. In this case, the protective layer 150 may be formed with only the one layer except the omitted layer.

A first contact hole 155 may be formed in the protective layer 150. According to aspects, the first contact hole 155 may be formed penetrating through the first protective layer 151 and the second protective layer 153, and may expose at least a portion of the protective layer 150 and the drain electrode 145.

A second contact hole 157 may be formed in the protective layer 150. According to aspects, the second contact hole 157 may be formed penetrating through the first protective layer 151 and the second protective layer 153, and may expose at least a portion of the protective layer 150 and the auxiliary electrode 147.

According to aspects, the second contact hole 157 may expose a side surface of the protective layer 150, and an angle between the side surface of the protective layer 150 exposed by the second contact hole 157 and a top surface of the protective layer 150 may be 90 degrees or less.

On the protective layer 150, a first electrode 161 may be placed. The first electrode 161 may be a conductive electrode for connecting at least two layers or at least two elements to each other. According to aspects, the first electrode 161 may be composed of a transparent conductive material, such as indium tin oxide (ITO), indium zinc oxide (IZO), zinc oxide (ZnO), or the like, but is not limited thereto.

The first electrode 161 may be connected to the drain electrode 145. A signal transmitted from the drain region 131c of the active pattern 131 may pass through the drain electrode 145 and may be transmitted to a lower electrode LE. In addition, the signal may be transmitted from the drain electrode 145 to the first electrode 161.

The first electrode 161 may be in contact with the drain electrode 145 via the first contact hole 155 penetrating through the protective layer 150. According to aspects, on the protective layer 150, the first electrode 161 may be placed along the first contact hole 155.

In addition, the first electrode 161 may be electrically connected to a first organic material layer 171 thereon, and may provide holes to the first organic material layer 171. For example, the first electrode 161 may function as an anode (negative) electrode.

On the protective layer 150, a partition wall 163 may be placed. The partition wall 163 may define an emission area EA of a pixel PX. The partition wall 163 may include an opening that exposes at least a portion of the first electrode 161, and may be formed in such a manner as to cover the remaining portion (for example, an edge) of the first electrode 161 which is not exposed. The exposed portion of the first electrode 161 may be defined as the emission area EA of the pixel PX.

According to aspects, the partition wall 163 may further include an opening that exposes a portion of the protective layer 150. That is, the partition wall 163 may be placed on a portion of the protective layer 150 rather than the whole protective layer 150.

According to aspects, the partition wall 163 may be placed to cover a portion of the auxiliary electrode 147 within the second contact hole 157, but is not limited thereto.

The partition wall 163 may be made of a material (for example, a colored material) capable of blocking light. Accordingly, light does not pass through the layers except the opening of the partition wall 163, but light passes only through the opening of the partition wall 163.

The partition wall 163 may include an organic material such as polyimide, benzocyclobutene series resin, acrylate, and the like. In addition, the partition wall 163 may include an inorganic material including silicon oxide, and silicon nitride. According to aspects, the partition wall 163 may be in a multi-layer structure including an organic material and an inorganic material.

On the first electrode 161, the first organic material layer 171 may be placed. According to aspects, the first organic material layer 171 may be placed on a portion in which the first electrode 161 is exposed, between the partition walls 163. For example, the first organic material layer 171 may be placed on the first electrode 161, being surrounded by the partition wall 163.

According to aspects, the partition wall 163 may be formed in such a manner as to be higher than the first organic material layer 171.

The first organic material layer 171 may output light in response to an electrical signal transmitted from the first electrode 161. According to aspects, the light output from the first organic material layer 171 may be any one among red light, green light, blue light, and white light, but aspects of the present disclosure are not limited thereto. For example, the color of the light output from the first organic material layer 171 may be one among magenta, cyan, and yellow colors.

The first organic material layer 171 may include a hole injection layer (HIL), a hole transport layer (HTL), and an organic emission layer. The hole injection layer (HIL) is placed on the first electrode 161, and holes are injected into the hole injection layer (HIL) from the first electrode 161. The hole transport layer (HTL) is placed on the hole injection layer and helps the injected holes to move. The organic emission layer emits light by itself using the holes transmitted from the hole transport layer and electrons provided from a second electrode 175, which will be described later.

The first organic material layer 171 may be formed in a tandem structure of two or more stacks. In this case, each of the stacks may include the hole injection layer, the hole transport layer, and the organic emission layer. In the case where the first organic material layer 171 is formed in the tandem structure of two or more stacks, a charge generation layer may be formed between the stacks. The charge generation layer may include an n-type charge generation layer and a p-type charge generation layer. The n-type charge generation layer is positioned near the lower stack. The p-type charge generation layer is formed on the n-type charge generation layer and is thus positioned near the upper stack. The n-type charge generation layer injects electrons into the lower stack, and the p-type charge generation layer injects holes into the upper stack. The n-type charge generation layer may be an organic layer obtained by doping, into an organic host material having electron transport capability, alkali metals, such as lithium (Li), sodium (Na), potassium (K), or cesium (Cs), or alkaline earth metals, such as magnesium (Mg), strontium (Sr), barium (Ba), or radium (Ra). The p-type charge generation layer may be an organic layer obtained by doping dopants into an organic host material having hole transport capability.

The first organic material layer 171 may be formed by an inkjet process of applying a solution containing an organic material onto a substrate, but aspects of the present disclosure are not limited thereto. For example, the first organic material layer 171 may also be formed by a deposition process or a laser transfer process.

According to aspects, in the case where the first organic material layer 171 is formed by the inkjet process, a surface of the first organic material layer 171 may be a curved surface. For example, the top surface of the first organic material layer 171 may have a concave or convex shape.

On the first organic material layer 171, a second organic material layer 173 and the second electrode 175 may be placed. The second organic material layer 173 may be placed along the surface of the first organic material layer 171, and the second electrode 175 may be placed along the surface of the second organic material layer 173. The second electrode 175 may be referred to as above any of the first organic material layer 171, the second organic material layer 173 or the protective layer 150 which would be understood to mean that the second electrode 175 is placed on these layers as described herein.

The second organic material layer 173 may be placed in such a manner as to cover the first organic material layer 171, and the second electrode 175 may be placed in such a manner as to cover the second organic material layer 173. According to aspects, the second organic material layer 173 may be placed along the surfaces of the first organic material layer 171, the partition wall 163, and the protective layer 150.

The second organic material layer 173 may transmit the electrons discharged from the second electrode 175, smoothly to the first organic material layer 171. For example, the second organic material layer 173 may include: an electron injection layer (EIL) into which the electrons discharged from the second electrode 175 are injected; and an electron transport layer (ETL) transporting the injected electrons to the first organic material layer 171.

The second electrode 175 may provide electrons to the first organic material layer 171. For example, the second electrode 175 may function as a cathode (positive) electrode. The second electrode 175 may include a transparent conductive material (TCO) capable of transmitting light, or a semi-transmissive conductive material including molybdenum (Mo), tungsten (W), silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), and an alloy thereof.

In an aspect of the present disclosure, the second electrode 175 may be placed along the second contact hole 157 that penetrates through the protective layer 150 and exposes at least a portion of the auxiliary electrode 147. In the meantime, the ductility of the second organic material layer 173 may be lower than the ductility of the second electrode 175, so that the second organic material layer 173 may not be placed along the second contact hole 157 and may be cut due to the difference in level of the protective layer 150 formed by the second contact hole 157. That is, the second organic material layer 173 may be discontinuous near the second contact hole 157.

Since the second organic material layer 173 is divided by the second contact hole 157, the exposed portion of the auxiliary electrode 147 within the second contact hole 157 is not covered by the second organic material layer 173. Accordingly, the second electrode 175 may be electrically connected to the auxiliary electrode 147 within the second contact hole 157. For example, the second electrode 175 may be in contact with the portion of the auxiliary electrode 147 which is exposed by the second contact hole 157, and the second electrode 175 may receive power from the auxiliary wire 129 through the auxiliary electrode 147. For example, the low-potential driving voltage ELVSS supplied through the auxiliary wire 129 may be supplied to the second electrode 175.

According to the aspects of the present disclosure, since the second electrode 175 may be connected to the auxiliary wire 129 through the auxiliary electrode 147, the power supplied through the auxiliary wire 129 is supplied stably to the second electrode 175, whereby a current may be supplied stably to the light-emitting element LD and the operating characteristics of the display panel 100 may be enhanced.

In the meantime, the partition wall 163 may be placed in at least a portion of the second contact hole 157. The second organic material layer 173 and the second electrode 175 may be placed on the partition wall 163 placed in the second contact hole 157. According to aspects, the slope of the partition wall 163 may be at an angle less than 50 degrees, and the second organic material layer 173 may be placed along the partition wall 163 without being cut.

An encapsulation layer 180 may be placed on the second electrode 175. The encapsulation layer 180 may prevent oxygen, moisture, or foreign matter from penetrating into a layer (for example, the organic material layers 171 and 173) under the encapsulation layer 180. According to aspects, the encapsulation layer 180 may be formed in a multi-layer structure including at least one inorganic layer and at least one organic layer. For example, the encapsulation layer 180 may be in a multi-layer structure in which an inorganic layer, an organic layer, and an inorganic layer are stacked in that order.

According to aspects, the organic layer may be thicker than the inorganic layer so as to prevent foreign matter from penetrating into the organic material layers 171 and 173. In addition, the organic layer may be made of a transparent material capable of transmitting light output from the first organic material layer 171, but is not limited thereto.

The inorganic layer may include at least one among a silicon nitride, an aluminum nitride, a zirconium nitride, a titanium nitride, a hafnium nitride, a tantalum nitride, a silicon oxide, an aluminum oxide, and a titanium oxide. The organic layer may include at least one among an acrylic resin, an epoxy resin, a phenolic resin, a polyamide resin, a benzocyclobutene resin, and a polyimide resin.

On the encapsulation layer 180, an upper substrate 190 may be formed. The upper substrate 190 may be composed of the same material as the substrate 110. The upper substrate 190 may be attached on the encapsulation layer 180 through an adhesive, or the like. However, the bonding method of the upper substrate 190 is not limited thereto.

In various aspects, between the encapsulation layer 180 and the upper substrate 190, a color filter 191 may be further formed. The color filter 191 may be placed in the emission area EA. The color filter 191 is a wavelength-selective optical filter that selectively transmits only a partial wavelength band of incident light by transmitting light in a particular wavelength band and blocking light in other particular wavelength bands. The color filter 191 may be composed of a photosensitive resin containing a colorant, such as a pigment, a dye, or the like. The light that is output from the light-emitting element LD and passes through the color filter 191 may have any one among red, green, and blue colors. In the case where the light-emitting element LD outputs white light, the color filter 191 for white light may be omitted.

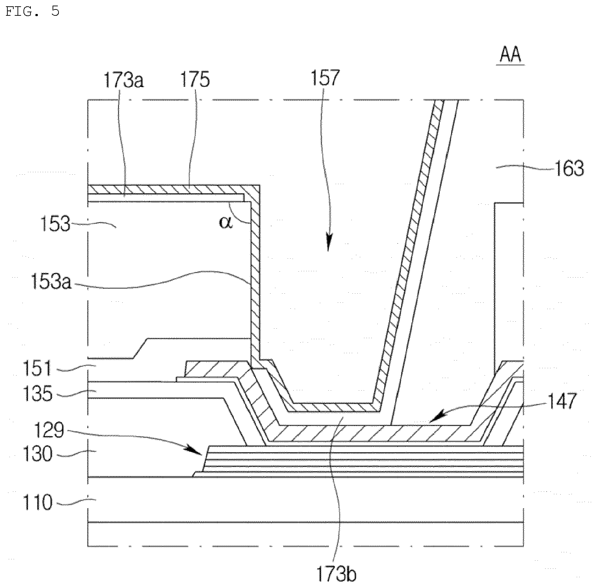

FIG. 5 is an enlarged view of portion AA shown in FIG. 4. Referring to FIGS. 1 to 5, the second contact hole 157 may expose a side surface of the protective layer 150 by penetrating through the protective layer 150. For example, the second contact hole 157 may penetrate through the protective layer 150 in such a manner that an angle α between a surface (for example, the top surface) of the protective layer 150 and an exposed surface 153a of the protective layer 150 which is exposed by the second contact hole 157 is equal to or less than 90 degrees. That is, the protective layer 150 may have a difference in level due to the second contact hole 157. For example, the protective layer 150 may have a reverse-tapered shape.

A step coverage refers to the degree to which a material or layer is capable of maintaining the thickness uniformly on a surface having a difference in level. For example, the step coverage for the difference in level between a first surface and a second surface bent at the first surface may be defined as (the thickness at the second surface) / (the thickness at the first surface), but is not limited thereto.

As the step coverage is high, a material or layer may be placed uniformly even on a surface having a difference in level. As the step coverage is high, a material or layer may be placed more uniformly along a surface having a difference in level.

In the present disclosure, the step coverage of the second organic material layer 173 may be worse than the step coverage of the second electrode 175. Accordingly, the second organic material layer 173 may not be placed in such a manner as to wholly cover the second contact hole 157, and may be cut due to the difference in level of the protective layer 150 formed by the second contact hole 157, while the second electrode 175 may be placed along the surface having the difference in level of the protective layer 150 formed by the second contact hole 157. In other words, the second organic material layer 173 may be unable to wholly cover the exposed surface 153a of the protective layer 150 exposed by the second contact hole 157, while the second electrode 175 may be placed in such a manner as to wholly cover the exposed surface 153a. For example, the second organic material layer 173 may be discontinuous within the second contact hole 157, and may include at least two parts 173a and 173b separated from each other within the second contact hole 157.

Herein, a portion of the auxiliary electrode 147 exposed by the second contact hole 157 may not be covered by the second organic material layer 173. For example, the auxiliary electrode 147 may be exposed between the two parts 173a and 173b of the second organic material layer 173 separated from each other. The second electrode 175 may be placed along the exposed surface 153a of the protective layer 150 in such a manner as to cover the second contact hole 157, and the second electrode 175 may be in contact with the auxiliary electrode 147. Accordingly, the second electrode 175 may be electrically connected to the auxiliary electrode 147. According to this configuration, the low-potential driving voltage ELVSS supplied through the auxiliary wire 129 may be supplied to the second electrode 175.

In the meantime, FIG. 5 shows that a first part 173a of the second organic material layer 173 is not placed on the exposed surface 153a of the protective layer 150. However, according to aspects, the first part 173a of the second organic material layer 173 may be placed in such a manner as to cover a portion of the exposed surface 153a. However, even in this case, the portion of the auxiliary electrode 147 exposed by the second contact hole 157 may not be covered by the second organic material layer 173.

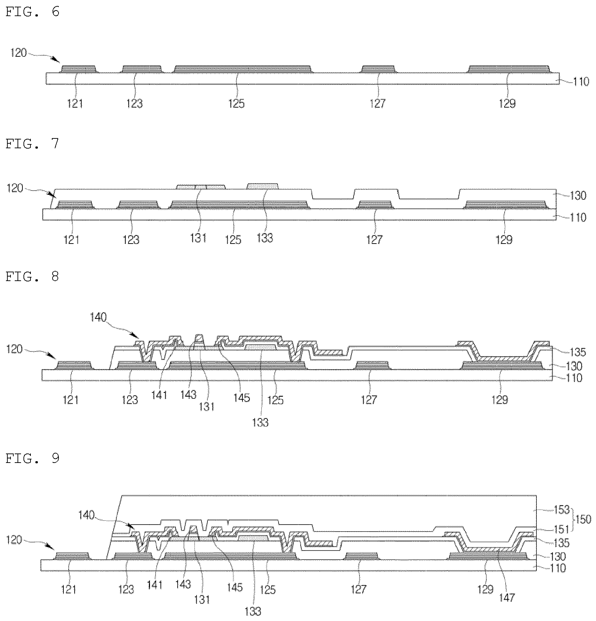

FIGS. 6 to 15 are diagrams showing a process of manufacturing a display panel according to aspects of the present disclosure. With reference to FIGS. 6 to 15, a process of manufacturing a display panel according to aspects of the present disclosure will be described.

Referring to FIG. 6, the substrate 110 may be provided, and on the substrate 110, the first conductive layer 120 may be formed. The first conductive layer 120 may include the pad 121, the power supply wire 123, the lower wire 125, the data line 127, and the auxiliary wire 129. As shown in FIG. 6, the first conductive layer 120 may be provided in a multi-layer structure including at least two metal layers, but aspects of the present disclosure are not limited thereto.

The first conductive layer 120 may be formed through a patterning process. According to aspects, the pad 121, the power supply wire 123, the lower wire 125, the data line 127, and the auxiliary wire 129 may be formed by applying (or depositing) a metal material on the substrate 110 and then performing patterning with use of a mask, but no limitation thereto is imposed.

Referring to FIG. 7, on the first conductive layer 120, the buffer layer 130 may be formed. For example, the buffer layer 130 may be formed by a deposition process.

On the buffer layer 130, the active pattern 131 and the storage electrode 133 may be formed. According to aspects, the oxide-based semiconductor material or the silicon-based semiconductor material may be applied on the buffer layer 130, and patterning may be performed by using a mask, thereby forming the active pattern 131.

According to aspects, the source region 131a and the drain region 131c of the active pattern 131 may be formed by performing heat treatment or ion implantation on the oxide-based semiconductor material or the silicon-based semiconductor material, but no limitation thereto is imposed.

Referring to FIG. 8, on the buffer layer 130, the insulation layer 135 may be formed. According to aspects, the insulation layer 135 may be placed in such a manner as to cover the buffer layer 130 and the active pattern 131. For example, an inorganic layer including a silicon oxide (SiOx) or a silicon nitride (SiNx) may be formed on the buffer layer 130 and the active pattern 131, and then the inorganic layer may be selectively subjected to patterning, thereby forming the insulation layer 135.

In addition, on the insulation layer 135, the second conductive layer 140 including the electrodes 141, 143, and 145 of the driving transistor DT and the auxiliary electrode 147 may be formed. According to aspects, by selectively performing patterning on the insulation layer 135, contact holes exposing the power supply wire 123, the lower wire 125, and the auxiliary wire 129, respectively, are formed, and the drain electrode 145, the source electrode 141, and the auxiliary electrode 147 may be formed in the respective contact holes.

Referring to FIG. 9, the protective layer 150 may be formed on the insulation layer 135 and the second conductive layer 140. The protective layer 150 may be formed to cover both the insulation layer 135 and the second conductive layer 140. According to aspects, after the first protective layer 151 is formed, the second protective layer 153 may be formed on the first protective layer 151. For example, the protective layer 150 may be formed by a deposition process.

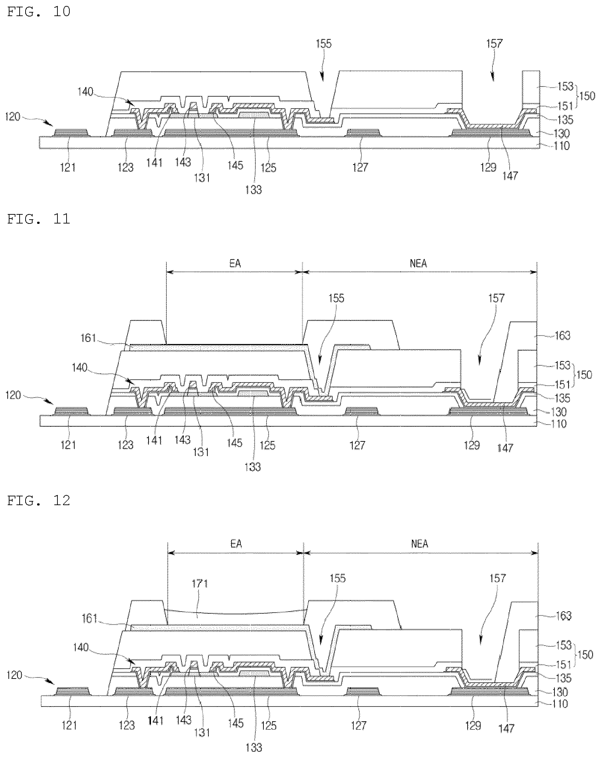

Referring to FIG. 10, in the protective layer 150, the contact holes 155 and 157 penetrating through the protective layer 150 may be formed. According to aspects, the contact holes 155 and 157 may be formed by etching the protective layer 150.

The first contact hole 155 may be formed by etching the protective layer 150 so that at least a portion of the drain electrode 145 is exposed. The second contact hole 157 may be formed by etching the protective layer 150 so that at least a portion of the auxiliary electrode 147 is exposed.

According to aspects, the second contact hole 157 penetrates through the protective layer 150, so that a side surface of the protective layer 150 may be exposed. As described above, the exposed surface 153a of the protective layer 150 exposed by the second contact hole 157 may have a reverse-tapered shape. For example, the second contact hole 157 may be formed through wet etching, but no limitation thereto is imposed.

Referring to FIG. 11, the first electrode 161 may be formed on the protective layer 150. According to aspects, at least a portion of the first electrode 161 may be formed in such a manner as to be placed along the first contact hole 155. Accordingly, the first electrode 161 may be in contact with the drain electrode 145 exposed through the first contact hole 155.

According to aspects, a transparent conductive material, such as indium tin oxide (ITO), indium zinc oxide (IZO), zinc oxide (ZnO), or the like, may be applied (or deposited) on the protective layer 150, and then patterning may be selectively performed by using a mask, thereby forming the first electrode 161.

On the first electrode 161, the partition wall 163 may be formed. According to aspects, the partition wall 163 may be formed on the first electrode 161 in such a manner as to expose a portion of the first electrode 161 and cover the remaining portion. In addition, the partition wall 163 may be formed in the second contact hole 157 in such a manner as to expose a portion of the auxiliary electrode 147 and cover the remaining portion.

An organic material or inorganic material may be applied on the protective layer 150 and the first electrode 161, and patterning may be selectively performed by using a mask, thereby forming the partition wall 163. Herein, through the patterning process, an opening exposing at least a portion of the first electrode 161 may be formed, and an opening exposing at least a portion of the auxiliary electrode 147 may be formed.

According to aspects, the partition wall 163 covering at least a portion of the auxiliary electrode 147 may be formed through wet etching, but no limitation thereto is imposed.

In the meantime, in this specification, it is described that after the first electrode 161 is subjected to patterning, the partition wall 163 is subjected to patterning. However, according to aspects, the first electrode 161 and the partition wall 163 may be formed through one patterning.

According to aspects, at least a portion of the surface of the partition wall 163 may be hydrophobic. For example, the partition wall 163 may be formed through a photolithography process after applying a solution that is a mixture of an organic insulation material and a hydrophobic material such as fluorine (F). Due the light emitted during the photolithography process, a hydrophobic material, such as fluorine, may move to the top of the partition wall 163, and accordingly, the top surface of the partition wall 163 has a hydrophobic property and the remaining portion may have a hydrophilic property. However, the present aspects are not limited thereto. The whole portion of the partition wall 163 may be hydrophobic. In the case where the whole partition wall 163 is hydrophobic, when the first organic material layer 171 outputting light of different colors is formed through an inkjet process, which will be described later, the partition wall 163 may serve as a dam that controls the flow in the first organic material layer 171.

Referring to FIG. 12, the first organic material layer 171 for outputting light may be formed. According to aspects, the first organic material layer 171 may be formed by depositing an organic material (a deposition process), applying a solution containing an organic material (an inkjet process), or irradiating a film containing an organic material with a laser (a laser transfer process), but aspects of the present disclosure are not limited thereto. However, the present disclosure is described assuming that the first organic material layer 171 is formed through the inkjet process.

The first organic material layer 171 may be formed on an exposed anode electrode 210, in the emission area EA surrounded by the partition wall 163. According to aspects, the first organic material layer 171 may be formed through the inkjet process in which an organic solution is dropped into a cavity surrounded by the partition wall 163 with use of a nozzle, or the like, and the organic solution is hardened. By the partition wall 163, the organic solution may be prevented from overflowing to the outside of the emission area EA.

According to aspects, when the first organic material layer 171 is formed through the inkjet process, there may be a difference in height between the central area of the first organic material layer 171 and the edge area (adjacent to the partition wall 163), due to the force between the first organic material layer 171 and the partition wall 163. For example, the top surface of the first organic material layer 171 may be thinnest at the central portion and may be thickest at the edge, but aspects of the present disclosure are not limited thereto.

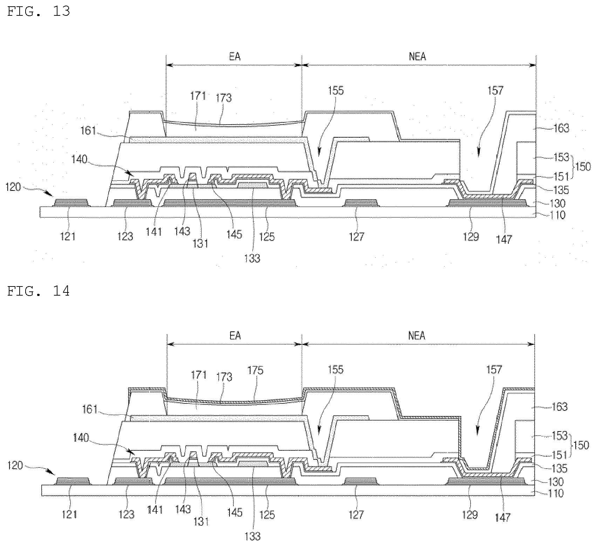

Referring to FIG. 13, the second organic material layer 173 may be formed on the first organic material layer 171. The second organic material layer 173 may be a layer for injecting or transporting the electrons transmitted from the second electrode 175.

According to aspects, the second organic material layer 173 may be formed by depositing an organic material (a deposition process), applying a solution containing an organic material (an inkjet process), or irradiating a film containing an organic material with a laser (a laser transfer process), but aspects of the present disclosure are not limited thereto. However, the present disclosure is described assuming that the second organic material layer 173 is formed through the deposition process.

The second organic material layer 173 may be deposited on the surface in such a manner as to cover the first organic material layer 171, the partition wall 163, and the protective layer 150. As described above, due to the reverse-tapered shape of the second contact hole 157, when the second organic material layer 173 is deposited, the second organic material layer 173 may be formed being separated by the difference in level of the protective layer 150 formed by the second contact hole 157. For example, the second organic material layer 173 may be formed (for example, deposited) in such a manner as to be discontinuous within the second contact hole 157, and may include two parts 173a and 173b separated from each other within the second contact hole 157. Accordingly, the auxiliary electrode 147 exposed by the second contact hole 157 may not be completely covered by the second contact hole 157, and may have at least a portion exposed.

Referring to FIG. 14, on the second organic material layer 173, the second electrode 175 may be formed. The second electrode 175 may be a cathode electrode capable of supplying electrons.

According to aspects, the second electrode 175 may be formed through a deposition process, but aspects of the present disclosure are not limited thereto.

The second electrode 175 may be deposited on the surface in such a manner as to cover the second organic material layer 173 and the protective layer 150. As described above, the second electrode 175 has better step coverage than the second organic material layer 173. Therefore, differently from the second organic material layer 173, the second electrode 175 may be placed in such a manner as not to be separated near the second contact hole 157 but to completely cover the second contact hole 157. That is, the second electrode 175 may be formed in such a manner as to be continuous within the second contact hole 157, and may be in direct contact with the exposed auxiliary electrode 147, accordingly. Therefore, since the second electrode 175 may be connected to the auxiliary wire 129 through the auxiliary electrode 147, the power supplied through the auxiliary wire 129 is supplied stably to the second electrode 175, whereby a current may be supplied stably to the light-emitting element LD.

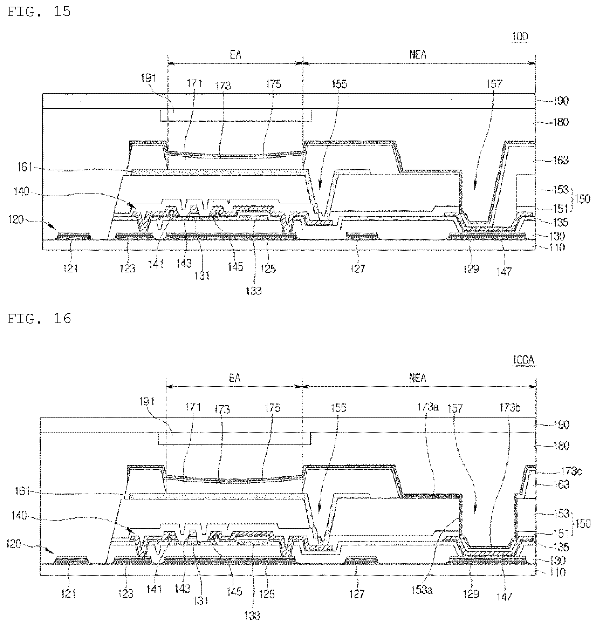

Referring to FIG. 15, on the second electrode 175, the encapsulation layer 180 may be formed. The encapsulation layer 180 may be formed in a multi-layer structure including an inorganic layer and an organic layer. According to aspects, the inorganic layer capable of preventing penetration of foreign matter or moisture from the outside may be formed, and the organic layer planarizing an irregularity of the lower structure may be formed on the inorganic layer. For example, the organic layer may be formed in such a manner as to be thicker than the inorganic layer.

On the encapsulation layer 180, the upper substrate 190 may be placed. According to aspects, the upper substrate 190 may be attached on the encapsulation layer 180 by using an adhesive, or the like.

In addition, between the upper substrate 190 and the encapsulation layer 180, the color filter 191 may be formed. According to aspects, the color filter 191 may be formed on a surface of the upper substrate 190 by being subjected to patterning, and the surface of the upper substrate 190 on which the color filter 191 is formed and the encapsulation layer 180 may be attached to each other. However, aspects of the present disclosure are not limited thereto.

FIG. 16 is a diagram showing a display panel according to aspects of the present disclosure. A display panel 100A of FIG. 16 and the display panel 100 of FIG. 4 differ in that a partition wall 163 of the display panel 100A is not placed within the second contact hole 157. A description of a part the same as that of the aspect of FIG. 4 will be omitted.

Referring to FIG. 16, the partition wall 163 may expose the whole second contact hole 157, and the partition wall 163 may not be formed on the auxiliary electrode 147. Since the partition wall 163 is not placed within the second contact hole 157, the second organic material layer 173 may be cut due to the difference in level of the protective layer 150 formed by the second contact hole 157, and may be placed in such a manner as to be discontinuous within the second contact hole 157.

According to aspects, the second organic material layer 173 may be discontinuous within the second contact hole 157, and may include at least three parts 173a, 173b, and 173c separated from each other within the second contact hole 157.

Herein, a portion of the auxiliary electrode 147 exposed by the second contact hole 157 may not be covered by the second organic material layer 173. For example, the auxiliary electrode 147 may be exposed between the three parts 173a, 173b, and 173c of the second organic material layer 173 separated from each other.

The second electrode 175 may be placed along the exposed surface 153a of the protective layer 150 in such a manner as to cover the second contact hole 157, and the second electrode 175 may be in contact with the auxiliary electrode 147 within the second contact hole 157. In the aspect of FIG. 16, the second electrode 175 may be in contact with the auxiliary electrode 147 at two parts separated from each other within the second contact hole 157. According to this configuration, the low-potential driving voltage ELVSS supplied through the auxiliary wire 129 may be supplied to the second electrode 175.

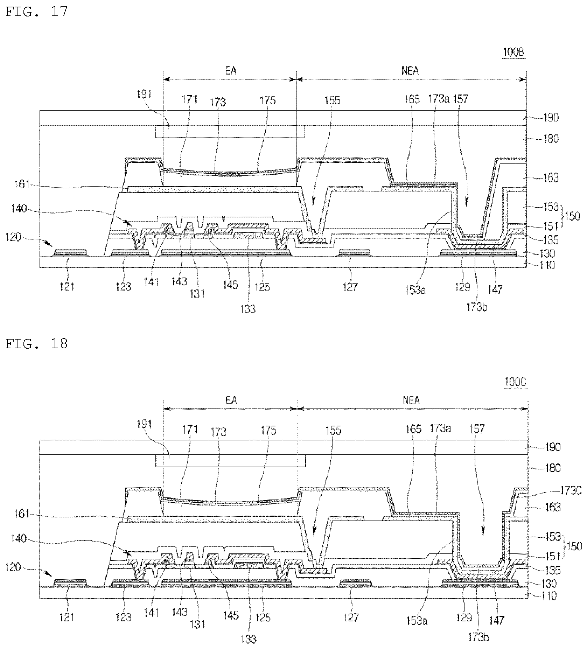

FIG. 17 is a diagram showing a display panel according to aspects of the present disclosure. A display panel 100B of FIG. 17 and the display panel 100 of FIG. 4 differ in that the display panel 100B further includes a third electrode 165 placed along the second contact hole 157. A description of a part the same as that of the aspect of FIG. 4 will be omitted.

Referring to FIG. 17, the third electrode 165 may be placed on the protective layer 150, being spaced apart from the first electrode 161.

The third electrode 165 may be substantially the same as the first electrode 161. According to aspects, the third electrode 165 may be composed of a transparent conductive material, such as indium tin oxide (ITO), indium zinc oxide (IZO), zinc oxide (ZnO), or the like. For example, a transparent conductive material may be applied on the protective layer 150 and the second contact hole 157, and then pattering may be performed by using a mask, thereby forming the third electrode 165.

The third electrode 165 may be formed by using the same mask as the first electrode 161, but no limitation thereto is imposed.

The third electrode 165 may be placed along the protective layer 150 in such a manner as to cover the second contact hole 157. The third electrode 165 may be placed throughout within the second contact hole 157, and may thus be electrically connected to the auxiliary electrode 147. According to aspects, the third electrode 165 may be placed with a constant thickness along the protective layer 150 and the exposed surface 153a of the protective layer 150 exposed by the second contact hole 157. That is, the third electrode 165 may be placed in such a manner as to maintain the difference in level in the second contact hole 157.

On the third electrode 165, a second organic material layer 173 may be placed. In the meantime, as described above, due to the step coverage of the second organic material layer 173, the second organic material layer 173 may not be placed in such a manner as to wholly cover the third electrode 165, and may be cut due to the difference in level of the third electrode 165 formed by the second contact hole 157. In contrast, the second electrode 175 may be placed along the surface having the difference in level of the third electrode 165 within the second contact hole 157. For example, the second organic material layer 173 may be discontinuous within the second contact hole 157, and may include at least two parts 173a and 173b separated from each other within the second contact hole 157.

Accordingly, at least a portion of the third electrode 165 is not covered by the second organic material layer 173. For example, the third electrode 165 may be exposed between the two parts 173a and 173b of the second organic material layer 173 separated from each other. The second electrode 175 may be placed in such a manner as to cover the third electrode 165, and the second electrode 175 may be in contact with the third electrode 165 within the second contact hole 157.

In the meantime, the partition wall 163 may be placed in at least a portion of the second contact hole 157. The partition wall 163 may be placed in such a manner as to cover at least a portion of the third electrode 165. The second organic material layer 173 and the second electrode 175 may be placed on the partition wall 163 placed in the second contact hole 157.

As described above, since the third electrode 165 is electrically connected to the auxiliary electrode 147, the second electrode 175 is electrically connected to the auxiliary electrode 147, consequently. According to this configuration, the low-potential driving voltage ELVSS supplied through the auxiliary wire 129 may be supplied to the second electrode 175.

FIG. 18 is a diagram showing a display panel according to aspects of the present disclosure. A display panel 100C of FIG. 18 and the display panel 100B of FIG. 17 differ in that a partition wall 163 of the display panel 100C is not placed within the second contact hole 157. A description of a part the same as that of the aspect of FIG. 17 will be omitted.

Referring to FIG. 18, the partition wall 163 may expose the whole second contact hole 157, and the partition wall 163 may not formed on the third electrode 165. Since the partition wall 163 is not placed within the second contact hole 157, the second organic material layer 173 may be cut due to the difference in level of the third electrode 165 formed by the second contact hole 157, and may be placed in such a manner as to be discontinuous within the second contact hole 157.

According to aspects, the second organic material layer 173 may be discontinuous within the second contact hole 157, and may include at least three parts 173a, 173b, and 173c separated from each other within the second contact hole 157.

Herein, at least a portion of the third electrode 165 is not covered by the second organic material layer 173. For example, the third electrode 165 may be exposed between the three parts 173a, 173b, and 173c of the second organic material layer 173 separated from each other.

The second electrode 175 may be placed along the surface having the difference in level formed by the second contact hole 157 in such a manner as to cover the third electrode 165, and the second electrode 175 may be in contact with the third electrode 165 within the second contact hole 157. In the aspect of FIG. 17, the second electrode 175 may be in contact with the third electrode 165 at two parts separated from each other within the second contact hole 157. According to this configuration, the low-potential driving voltage ELVSS supplied through the auxiliary wire 129 may be supplied to the second electrode 175.

According to the aspects of the present disclosure, the second electrode 175 corresponding to the cathode electrode of the light-emitting element LD may be connected to the auxiliary wire 129 through the auxiliary electrode 147, so that the power supplied through the auxiliary wire 129 may be supplied stably to the second electrode 175.

Accordingly, a current may be supplied stably to the light-emitting element LD of the aspects of the present disclosure.

In addition to the above, the following clauses are also provided:
1. A display panel comprising:
   a substrate including an emission area and a non-emission area;
   a driving element for driving the display panel;
   an auxiliary electrode placed in the non-emission area and spaced apart from the driving element;
   a protective layer placed on the driving element and the auxiliary electrode;
   a first electrode placed on the protective layer and connected to the driving element;
   a first organic material layer placed on the first electrode;
   a second electrode placed above the first organic material layer and the protective layer;
   a second organic material layer placed between the second electrode and the first organic material layer; and
   a contact hole penetrating through the protective layer and exposing the auxiliary electrode,
   wherein the second electrode is electrically connected to the auxiliary electrode within the contact hole.
2. The display panel of clause 1, wherein the second electrode is placed to be continuous within the contact hole, and wherein the second organic material layer is placed to be discontinuous within the contact hole.
3. The display panel of clauses 1 or 2, wherein an angle between a top surface of the protective layer and an exposed surface of the protective layer exposed by the contact hole is equal to or greater than 80 degrees and equal to or less than 90 degrees.
4. The display panel of any preceding clause, wherein the first organic material layer has a curved surface.
5. The display panel of any preceding clause, wherein the second electrode is in contact with the auxiliary electrode within the contact hole.
6. The display panel of any preceding clause, wherein the second organic material layer is divided into at least two parts separated from each other within the contact hole, and
   wherein the second electrode is in contact with the auxiliary electrode between the at least two parts of the second organic material layer.
7. The display panel of any preceding clause, wherein the second electrode covers the at least two parts of the second organic material layer.
8. The display panel of any preceding clause, further comprising a partition wall covering a portion of the auxiliary electrode,
   wherein one of the at least two parts of the second organic material layer covers the partition wall, and
   wherein the second electrode covers the contact hole and the partition wall.
9. The display panel of any preceding clause, wherein the second organic material layer includes three parts spaced apart from one another within the contact hole, and
   wherein the second electrode is in contact with the auxiliary electrode exposed between the three parts of the second organic material layer.
10. The display panel of any preceding clause, further comprising a third electrode insulated from the first electrode and placed between the protective layer and the second organic material layer,
   wherein the third electrode is in contact with the auxiliary electrode within the contact hole, and
   wherein the second electrode is electrically connected to the third electrode.
11. The display panel of clause 10, wherein the second organic material layer includes at least two parts placed on the third electrode and spaced apart from each other, and
   wherein the second electrode is in contact with the third electrode between the at least two parts of the second organic material layer.
12. The display panel of any preceding clause, wherein the second electrode covers the at least two parts of the second organic material layer.
13. The display panel of any of clauses 10 to 12, further comprising a partition wall covering a portion of the third electrode within the contact hole,
   wherein one of the at least two parts of the second organic material layer covers the partition wall, and
   wherein the second electrode covers the contact hole and the partition wall.
14. The display panel of any of clauses 10 to 13, wherein the third electrode entirely covers the contact hole,
   wherein the second organic material layer includes three parts placed on the third electrode and spaced apart from one another, and
   wherein the second electrode is in contact with the third electrode exposed between the three parts of the second organic material layer.
15. A method of manufacturing a display panel, the method comprising:
   forming a driving element on a substrate for driving the display pane and an auxiliary electrode on the substrate spaced apart from the driving element;
   forming a protective layer on the driving element and the auxiliary electrode;
   forming a first electrode connected to the driving element;
   forming a contact hole in the protective layer and exposing the auxiliary electrode;
   forming a first organic material layer on the first electrode;
   forming a second organic material layer on the first organic material layer and the protective layer; and
   forming a second electrode to cover the second organic material layer,
   wherein the forming the second organic material layer includes forming the second organic material layer placed to be discontinuous within the contact hole.
16. The method of clause 15, wherein the forming of the contact hole comprises:
   forming the contact hole penetrating through the protective layer so that an angle between a top surface of the protective layer and an exposed surface of the protective layer exposed by the contact hole is equal to or greater than 80 degrees and equal to or less than 90 degrees.
17. The method of clause 15 or 16, wherein the second electrode is in contact with the auxiliary electrode within the contact hole.
18. The method of any of clauses 15 to 17, wherein the first organic material layer is formed by applying a solution containing an organic material,
   wherein the second organic material layer is formed by depositing an organic material, and
   wherein the second electrode is formed by depositing a conductive material on the second organic material layer.
19. The method of any of clauses 15 to 18, further comprising forming a third electrode insulated from the first electrode, and placed between the protective layer and the second organic material layer,
   wherein the third electrode is in contact with the auxiliary electrode within the contact hole, and
   wherein the second electrode is electrically connected to the third electrode.
20. A display device, comprising:
   a display panel comprising:
      a substrate including an emission area and a non-emission area;
      a driving element for driving the display panel;
      an auxiliary electrode placed in the non-emission area and spaced apart from the driving element;
      a protective layer placed on the driving element and the auxiliary electrode;
      a first electrode placed on the protective layer and connected to the driving element;
      a first organic material layer placed on the first electrode;
      a second electrode placed above the first organic material layer and the protective layer;
      a second organic material layer placed between the second electrode and the first organic material layer; and
      a contact hole penetrating through the protective layer and exposing the auxiliary electrode,
   wherein the second electrode is electrically connected to the auxiliary electrode within the contact hole.

The present disclosure has been described with reference to the aspects shown in the drawings for illustrative purposes, and those skilled in the art to which the present disclosure pertains will easily understand that the present disclosure may be modified in various ways and that other equivalent aspects are possible. Accordingly, the scope of the present disclosure should be determined by the technical idea of the appended claims.

## Claims

1. A display panel comprising:
a substrate including an emission area and a non-emission area;
a driving element for driving the display panel;
an auxiliary electrode placed in the non-emission area and spaced apart from the driving element;
a protective layer placed on the driving element and the auxiliary electrode;
a first electrode placed on the protective layer and connected to the driving element;
a first organic material layer placed on the first electrode;
a second electrode placed above the first organic material layer and the protective layer;
a second organic material layer placed between the second electrode and the first organic material layer; and
a contact hole penetrating through the protective layer and exposing the auxiliary electrode,
wherein the second electrode is electrically connected to the auxiliary electrode within the contact hole.

2. The display panel of claim 1, wherein the second electrode is placed to be continuous within the contact hole, and
wherein the second organic material layer is placed to be discontinuous within the contact hole; and/or
wherein the second electrode is in contact with the auxiliary electrode within the contact hole.

3. The display panel of claims 1 or 2, wherein an angle between a top surface of the protective layer and an exposed surface of the protective layer exposed by the contact hole is equal to or greater than 80 degrees and equal to or less than 90 degrees.

4. The display panel of any preceding claim, wherein the first organic material layer has a curved surface.

5. The display panel of any preceding claim, wherein the second organic material layer is divided into at least two parts separated from each other within the contact hole, and
wherein the second electrode is in contact with the auxiliary electrode between the at least two parts of the second organic material layer

6. The display panel of claim 5, wherein the second electrode covers the at least two parts of the second organic material layer; and
optionally:
wherein the second organic material layer includes three parts spaced apart from one another within the contact hole, and
wherein the second electrode is in contact with the auxiliary electrode exposed between the three parts of the second organic material layer.

7. The display panel of any preceding claim, further comprising a partition wall covering a portion of the auxiliary electrode,
wherein one of the at least two parts of the second organic material layer covers the partition wall, and
wherein the second electrode covers the contact hole and the partition wall.

8. The display panel of any preceding claim, further comprising a third electrode insulated from the first electrode and placed between the protective layer and the second organic material layer,
wherein the third electrode is in contact with the auxiliary electrode within the contact hole, and
wherein the second electrode is electrically connected to the third electrode; and
optionally:
wherein the second organic material layer includes at least two parts placed on the third electrode and spaced apart from each other, and
wherein the second electrode is in contact with the third electrode between the at least two parts of the second organic material layer.

9. The display panel of claims 7 or 8, further comprising a partition wall covering a portion of the third electrode within the contact hole,
wherein one of the at least two parts of the second organic material layer covers the partition wall, and
wherein the second electrode covers the contact hole and the partition wall.

10. The display panel of any of claims 7 to 9, wherein the third electrode entirely covers the contact hole,
wherein the second organic material layer includes three parts placed on the third electrode and spaced apart from one another, and
wherein the second electrode is in contact with the third electrode exposed between the three parts of the second organic material layer.

11. A method of manufacturing a display panel, the method comprising:
forming a driving element on a substrate for driving the display pane and an auxiliary electrode on the substrate spaced apart from the driving element;
forming a protective layer on the driving element and the auxiliary electrode;
forming a first electrode connected to the driving element;
forming a contact hole in the protective layer and exposing the auxiliary electrode;
forming a first organic material layer on the first electrode;
forming a second organic material layer on the first organic material layer and the protective layer; and
forming a second electrode to cover the second organic material layer,
wherein the forming the second organic material layer includes forming the second organic material layer placed to be discontinuous within the contact hole.

12. The method of claim 11, wherein the forming of the contact hole comprises:
forming the contact hole penetrating through the protective layer so that an angle between a top surface of the protective layer and an exposed surface of the protective layer exposed by the contact hole is equal to or greater than 80 degrees and equal to or less than 90 degrees; and/or
wherein the second electrode is in contact with the auxiliary electrode within the contact hole.

13. The method of claims 11 or 12, wherein the first organic material layer is formed by applying a solution containing an organic material,
wherein the second organic material layer is formed by depositing an organic material, and
wherein the second electrode is formed by depositing a conductive material on the second organic material layer.

14. The method of any of claims 11 to 13, further comprising forming a third electrode insulated from the first electrode, and placed between the protective layer and the second organic material layer,
wherein the third electrode is in contact with the auxiliary electrode within the contact hole, and
wherein the second electrode is electrically connected to the third electrode.

15. A display device, comprising:
a display panel according to any of claims 1 to 10.
